Europäisches Patentamt

European Patent Office

Office européen des brevets

(11) Publication number: **0 200 230 B1**

# EUROPEAN PATENT SPECIFICATION

(45) Date of publication of patent specification: **04.09.91**   (51) Int. Cl.⁵: **H03K 19/094**

(21) Application number: **86106035.8**

(22) Date of filing: **02.05.86**

(54) Logic integrated circuit device formed on compound semiconductor substrate.

(30) Priority: **02.05.85 JP 94905/85**

(43) Date of publication of application:
**05.11.86 Bulletin 86/45**

(45) Publication of the grant of the patent:
**04.09.91 Bulletin 91/36**

(84) Designated Contracting States:
**DE FR GB**

(56) References cited:
**EP-A- 0 085 569**
**US-A- 4 028 556**

**IEEE JOURNAL OF SOLID-STATE CIRCUITS,
vol. SC-19, no. 5, October 1984, pages
710-715, New York, US; S. SHIMIZU et al.: "A 1
GHz 50 mW GaAs Dual Modulus Divider IC"**

**E. Hölzler, H. Holzwarth "Pulstechnik - Band
II, Anwendungen und Systeme", Springer
Verlag, Berlin, Heidelberg, New York 1976,
pages 155-156**

(73) Proprietor: **NEC CORPORATION**
**7-1, Shiba 5-chome Minato-ku**
**Tokyo 108-01(JP)**

(72) Inventor: **Hirayama, Hiromitsu**
**c/o NEC Corporation 33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**W-8000 München 26(DE)**

## Description

## BACKGROUND OF THE INVENTION

The present invention relates to a logic integrated circuit device formed on a compound semiconductor substrate and more particularly, to such a device which is compatible with a silicon emitter-coupled logic integrated circuit device.

As well known in the art, an integrated circuit device formed on a substrate of compound semiconductor, typically of gallium arsenide, (called therefore hereinafter as a "GaAs IC") attains a very high speed operation, and therefore it is desired that a silicon emitter-coupled logic integrated circuit device (Si-ECL IC) which is usually employed in a high speed system is replaced by the GaAs IC.

For the GaAs IC to have the compatibility with the Si-ECL IC, the following three conditions should be satisfied:

(1) Compatibility in a power supply voltage and logic levels. More specifically, the power supply voltage of GaAs IC should be -5.2 $\overline{V}$, and its logic levels should be -0.7 $\overline{V}$ (high level) and -1.9 $\overline{V}$ (low level).

(2) Compatibility in logic operation. In particular, true and complementary signals should be produced without a time delay.

(3) Compatibility in a load drive capability. A load of 50Ω should be driven directly.

The inventor developed a prototype GaAs IC, but which satisfied the above three conditions at the sacrifice of a power consumption and a semiconductor chip area. More specifically, some of transistors in the prototype GaAs IC were connected in series between power supply terminals. The power supply voltage applied to the IC was -5,2 $\overline{V}$, so that each of the series-connected transistors was supplied with a small voltage across its source and drain. Therefore, the threshold voltage thereof had to be designed to be of a shallow value. All the transistors in the prototype GaAs IC were fabricated through the same steps, and thus took the same threshold voltage. As a result, the threshold voltage of an output transistor became shallow inevitably. On the other hand, the output transistor should drive to 50Ω load and produce an output signal having the ECL level. Therefore, the output transistor is required to have a considerably large current ability. In order for the output transistor to have a large current ability with a shallow threshold voltage, its gate width was made large remarkably. As a result, the area on a semiconductor chip occupied by the output transistor was made large.

The transistor having a large gate width increases its input stray capacitance. For this reason, a plurality of buffer amplifiers were required to drive the output transistor. As a result, a large power was consumed by the buffer amplifiers. The amplifiers also increase the chip area.

US 4 028 556 discloses an integrated logic circuit in which the current drivability of the output stage is larger than that of the input stage. In this device one of the transistors constituting the logic circuit has a threshold voltage larger in absolutely value than that of each of the transistors constituting the remaining part of the logic circuit. Therefore, the stray capacitance at the connecting node becomes large so that the operation speed is lowered and large power is consumed. Furthermore, the produced logic levels are not compatible with those of Si-ECLIC.

In IEEE Journal of Solid-State Circuits, SC-19, No. 5, October 1984, pp. 710-715, a GaAs integrated circuit is disclosed in which a large current drivability of a source follower stage is achieved. The source follower stage is a part of a logic circuit and, therefore, the operation speed is lowered and large power is consumed.

An integrated circuit device according to the preamble part of the claim is described in EP-A-0 085 569. In this integrated circuit the output stage is composed of two elements, a transistor and a diode, in order to achieve the desired output levels. The output transistor is required to supply the load with relatively large currents, so that it has to be fabricated with large occupying area and enlarges the stray capacitance thereof so that the operation speed is thereby lowered.

From E. Hölzler, N. Holzwarth, "Pulstechnik - Band II, Anwendungen und Systeme", Springer Verlag, 1976, pp. 155, 156, it is known from ECL-logic elements to use an externally terminating power supply of 2 V as a design measure for reducing power consumption.

It is the object of the invention to provide an integrated circuit device according to the preamble part of the claim which has a reduced chip area for a predefined output current.

This object is achieved by an integrated circuit device comprising a gallium arsenide substrate, a first power terminal supplied with a ground voltage, a second power terminal supplied with a first negative voltage substantially equal to -5.2 V, a compound semiconductor substrate, a plurality of transistors formed on said compound semiconductor substrate, said plurality of transistors constituting a logic circuit connected between said first and second power terminals, an ECL- compatible output terminal, and an output transistor formed on said compound semiconductor substrate, connected between said first power terminal and said output terminal and having a first threshold voltage, said output terminal being connected through an externally provided load of 50 ohms to a potential source terminal, wherein all of said plurality of transistors have a second threshold voltage within a range from -0.2V to - 0.3V and wherein said first threshold voltage is within a range from -0.6V to -0.9V, said potential source terminal is supplied with a second negative voltage, the source of said output transistor is connected directly to the output terminal, and wherein said output transistor is turned OFF in response to a first state of an output from said logic circuit and turned ON in response to a second state of said output from said logic circuit to produce logic levels that are compatible with those of silicon emitter-coupled logic integrated circuit devices.

Thus, the output transistor has a deeper threshold voltage and hence a large current value with a considerably small gate width. Therefore, the chip area occupied by the output transistor is made small. The input stray capacitance of the output transistor is also decreased, and accordingly only one or no buffer amplifier is required to drive the output transistor. The power consumption is thereby reduced and the chip area is further decreased.

BRIEF DESCRIPTION OF THE DRAWINGS

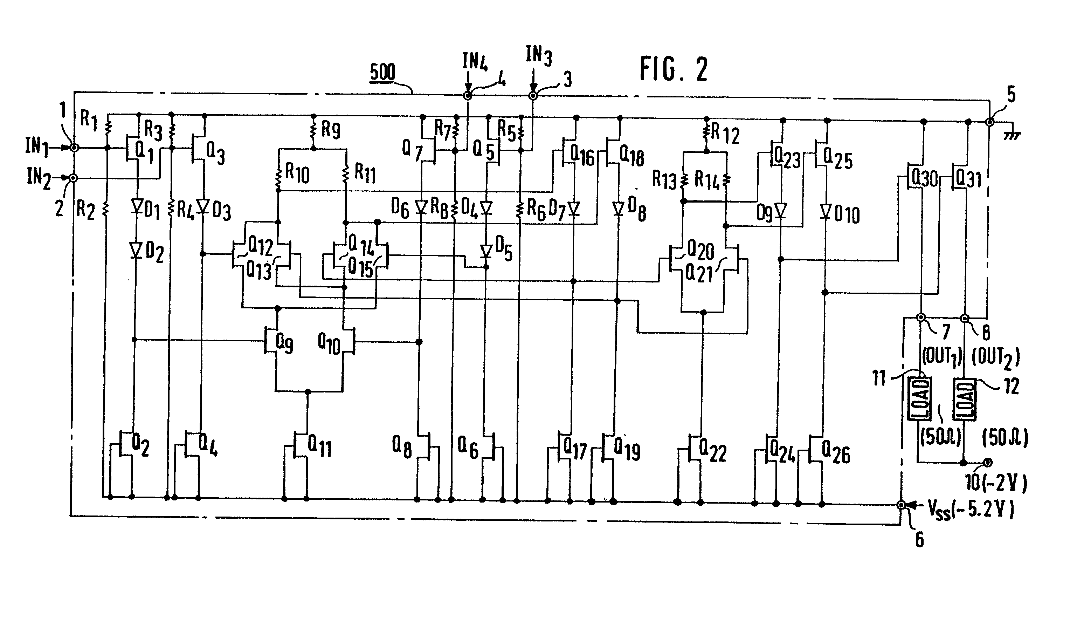

The above and other objects, advantages and features of the present invention will be more apparent from the following description taken in conjunction with the accompanying drawings, in which
Fig. 1
is an equivalent circuit diagram of a prototype GaAs IC;
Fig. 2
is an equivalent circuit diagram of a GaAs IC according to an embodiment of the present invention;
Fig. 3
is a graph showing a realationship between a gate width and a drain current of a Schottky junction field effect transistor; and
Fig. 4 to Fig. 8
are cross-sectional views of a part of the GaAs IC in Fig. 2 representing manufacturing steps.

DESCRIPTION OF PRIOR ART

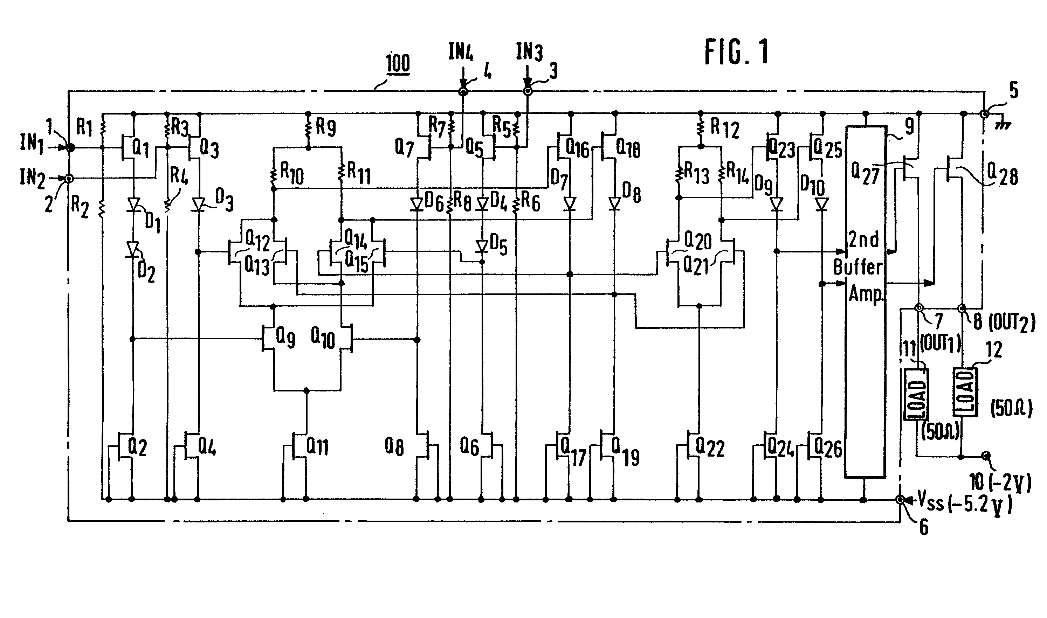

With reference to Fig. 1, a prototype GaAs IC will be described in order to facilitate the understanding of the present invention.

In Fig. 2, a GaAs IC 100 has four input terminals 1 to 4, two output terminals 7 and 8, and two power supply terminals 5 and 6. The first input terminal 1 is connected to the gate of a transistor $Q_9$ via a first input circuit which is composed of a source follower transistor $Q_1$, a current source transistor $Q_2$, two level shift diodes $D_1$ and $D_2$, and two

bias resistors $R_1$ and $R_2$. The second input terminal 2 is connected to the gate of a transistor $Q_{12}$ through a second input circuit composed of a source follower transistor $Q_3$, a current source transistor $Q_4$, a level shift diode $D_3$, and bias resistors $R_3$ and $R_4$. The third input terminal 2 is connected via a third input circuit to the gate of a transistor $Q_{15}$. The third input circuit is constituted of a source follower transistor $Q_5$, a current source transistor $Q_6$, level shift diodes $D_4$ and $D_5$, and bias resistors $R_5$ and $R_6$. The fourth input terminal 4 is connected to the gate of a transistor $Q_{10}$ via a fourth input circuit which is composed of a source follower transistor $Q_7$, a current source transistor $Q_8$, a level shift diode $D_6$, and bias resistors $R_7$ and $R_8$.

The transistors $Q_9$ and $Q_{10}$ constitutes a differential circuit, and the source connection point thereof is connected to a current source transistor $Q_{11}$. The transistors $Q_{12}$ and $Q_{15}$ also constitutes a differential cirucit, and a transistor $Q_9$ operates as a current source thereof. A transistor $Q_{11}$ operates as a current source of a differential circuit composed of the transistors $Q_{13}$ and $Q_{14}$. The drains of the transistors $Q_{12}$ and $Q_{13}$ are connected in common to one ends of a load resistor $R_{10}$ and further to the gate of a transistor $Q_{16}$. The drains of the transistors $Q_{14}$ and $Q_{15}$ are connected in common to one end of a load resistor $R_{11}$ and to the gate of a source follower transistor $Q_{18}$. The other ends of the load resistors $R_{10}$ and $R_{11}$ are connected via a level adjusting resistor $R_9$ to the first power supply terminal 5. The source outputs of the transistors $Q_{16}$ and $Q_{18}$ are fed back through diodes $D_7$ and $D_8$ to the gates of the transistors $Q_{14}$ and $Q_{13}$, respectively. Transistors $Q_{17}$ and $Q_{19}$ constitutes a current source. The transistors $Q_9$ to $Q_{15}$ and the resistors $R_9$ to $R_{11}$ thus constitutes a differential type logic circuit which functions as a latch circuit.

The outputs of the source follower transistors $Q_{16}$ and $Q_{13}$ are supplied through the diodes $D_7$ and $D_8$ to a first buffer amplifier which is composed of transistors $Q_{20}$ to $Q_{26}$, resistors $R_{12}$ to $R_{14}$ and diodes $D_9$ and $D_{10}$. In this buffer amplifier, the transistors $Q_{20}$ and $Q_{21}$ are connected in a differential form, and the transistor $Q_{22}$ is a current source. The resistors $R_{13}$ and $R_{14}$ are load resistors and $R_{12}$ is a level adjusting resistor. The transistors $Q_{23}$ to $Q_{26}$ and the diodes $D_9$ and $D_{10}$ constitute a level shift circuit. The outputs of the first buffer amplifier are supplied to a second buffer amplifier 9. The second buffer amplifier 9 has the same construction as the first amplifier and therefore is respresented as a block circuit.

The outputs of the second buffer amplifier 9 are supplied respectively to source follower transistors $Q_{27}$ and $Q_{28}$ which have their sources connected respectively to the output terminals 7 and 8 and operate as output transistors. The output terminals 7 and 8 are connected respectively to an external power terminal 10 and further to a subsequent stage circuit (not shown).

Each of the transistors $Q_1$ to $Q_{28}$ is of an N-channel type and a Schottky junction type field effect transistor.

The inventor developed the prototype GaAs IC 100, so that he clarified that the IC 100 sacrificed the power consumption and the chip area for the compatibility with an Si-ECL IC and for a high speed operation.

More specifically, the latch circuit including the transistors $Q_9$ to $Q_{15}$ and the buffer amplifiers employed a differential type logic circuit to produce true and complementary signals. The above mentioned condition (2) for the compatibility was thus satisfied. For the condition (1), the first power supply terminal 5 was grounded and the second power supply terminal 6 was applied with a $V_{SS}$ potential of -5.2 $\overline{V}$. The input terminals 1 and 4 and thoses 2 and 3 where used respectively as a pair of input terminals. Accordingly, one of the terminals 1 and 4 and one of those 2 and 3 were often in an open state. Each of input signals $IN_1$ to $IN_4$ took on ECL level in which a high level and a low level were -0.7 $\overline{V}$ and -1,9 $\overline{V}$, respectively. Therefore, the resistance values of the resistors $R_1$, $R_3$, $R_5$ and $R_7$ were 1,3K$\Omega$ , and those of the resistors $R_2$, $R_4$, $R_6$ and $R_8$ were 4.9K$\Omega$ , so that the gate biases of the transistors $Q_1$, $Q_3$, $Q_5$ and $Q_7$ were designed to be an intermediate level of the high level and the low level of the input signal IN. As a result, the compatibility was also satisfied with respect to the input signal logic level.

The elektron mobility in a gallium arsenide semiconductor is larger than that in a silicon semiconductor, and in order to get this effect sufficiently, all the transistors in the GaAs IC are required to operate their saturated region in which a drain current is approximately constant against the change in a drain-source voltage, Therefore, the following relationship (1) should be satisfied:

$$V_{DS} > V_{DS(SAT)} = V_{GS} - V_T \quad (1)$$

wherein $V_{DS}$ is a voltage between source and drain; $V_{DS(SAT)}$ is a drain-source voltage at a saturation point; $V_{GS}$ is a gate-source voltage; and $V_T$ is a threshold voltage. The conductance of the transistor is increased by a large $V_{GS}$, so that the transistor operates at a high speed. However, when $V_{GS}$ exceeds 0.6 $\overline{V}$, the Schottky gate is forward biased, so that a gate current flows. Therefore, $V_{GS}$ is designed to be within a range between 0.4 $\overline{V}$ and 0.6 $\overline{V}$.

Turning back to Fig. 2, in the latch circuit composed of the transistors $Q_9$ to $Q_{15}$ and the

resistors $R_9$ to $R_{11}$, a current path was formed between the power supply terminals 5 and 6, which consisted of the resistor $R_9$, the resistor $R_{10}$ (or $R_{11}$), the transistor $Q_{12}$ (or $Q_{13}$, $Q_{14}$, $Q_{15}$) the transistor Q9 (or $Q_{10}$), and the transistor $Q_{11}$. In other words, three transistors, one load resistor and one level adjusting resistor were connected in series between the power terminals 5 and 6. The absolute value of the power voltage was 5.2 $\overline{V}$. Accordingly, assuming that the voltage drop across the level adjusting resistor $R_9$ was $V_{R9}$ and that across the load resistor $R_{10}$ (or $R_{11}$) was $V_{LS}$, a voltage $V_{DSA}$ supplied across the series connection of three transistors was as follows:

$$V_{DSA} (= 3 V_{DS}) = 5.2 - V_{R9} - V_{LS} \quad (2)$$

The voltage drop $V_{LS}$ across the resistor $R_{10}$ (or $R_{11}$) was an amplitude of signals supplied to the transistors $Q_{14}$ (or $Q_{13}$) and $Q_{20}$ (ord $Q_{21}$) and tooks 2 $\overline{V}$ to obtain a switching operation in these transistors. The voltage drop $V_{R9}$ across the resistor $R_9$ required 0.6 $\overline{V}$ in order that the transistors $Q_{12}$ and $Q_{13}$ and those $Q_{14}$ and $Q_{15}$ operated in a differential form. Therefore, the voltage $V_{DSA}$ was under 2.6 $\overline{V}$ from the equation (2). The respective drain-source voltages of the series- connected three transistors were thereby about 0.8 $\overline{V}$. As mentioned hereinbefore, the gate-source voltage $V_{GS}$ of 0.4 to 0.6 $\overline{V}$ was supplied to each of those three transistors. As a result, the threshold voltage $V_T$ of the respective transistors took -0.2 to -0.3 $\overline{V}$ from the relationship (1) and could not be designed to be more deeply than this value. All the transistors in the IC 100 were manufactured by the same steps, and therefore the remaining transistors $Q_1$ to $Q_8$ and $Q_{16}$ to $Q_{28}$ also took their threshold voltage of -0.2 to -0.3 $\overline{V}$.

For the condition (3) in the compatibility with the Si-ECL IC, one end of loads 11 and 12 of 50$\Omega$ were connected directly to the output terminals 7 and 8, respectively. It was apparent that output signals $OUT_1$ and $OUT_2$ derived from the output terminals 7 and 8 had to take -0,7 $\overline{V}$ high level and -1.9 $\overline{V}$ low level. When the output transistors $Q_{27}$ and $Q_{28}$ were in OFF, the output signals $OUT_1$ and $OUT_2$ took the low level of about -1.9 $\overline{V}$, because the other ends of the load 11 and 12 were connected to the potential terminals 10 supplied With -2 $\overline{V}$. In order to obtain the high level of about-0.7$\overline{V}$, the output transistors $Q_{27}$ and $Q_{28}$ were required to have current ability of 20 to 24 mA. Such relatively large current ability was realized by increasing considerably the gate width of the transistors $Q_{27}$ and $Q_{28}$.

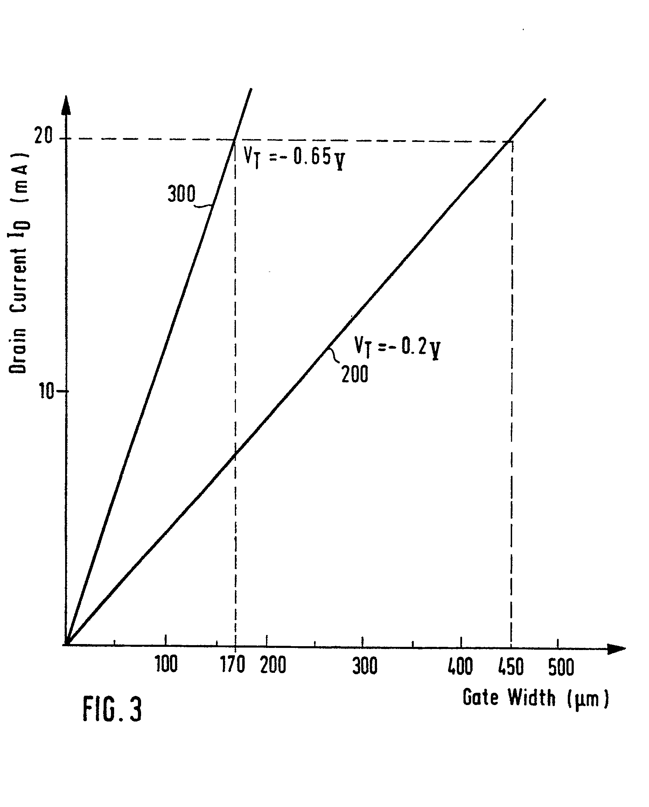

Fig. 3 shows the relationship of the drain current $I_{DS}$ to the gate width. Since the threshold voltages $V_T$ of the transistors $Q_{27}$ and $Q_{28}$ were

-0.2 $\bar{V}$, that relationship is represented by a line 200. The gate width of 450 $\mu$m was recessitated for the current ability of 20 mA.

Thus, the GaAs IC 100 required the considerably large sized output transistors $Q_{27}$ and $Q_{28}$, so that the area of a semiconductor chip was enlarged. Since the gate widths of the transistors $Q_{27}$ and $Q_{28}$ were large, their input stray capacitors were made large remarkably. For this reason, it was impossible that the transistors $Q_{27}$ and $Q_{28}$ are driven only by the transistors $Q_{23}$ and $Q_{25}$ at a high speed. Therefore, the second buffer amplifier 9 was inserted between the first amplifier and the output transistors. Buffer amplifiers more than two were often provided. The respective transistors in the buffer amplifier 9 were required to have a relatively large gate width in order to drive a considerably large load capacitance, so that the power consumption of the amplifier was increased. The chip area was further enlarged. As described above, the GaAs IC 100 having the compatibility with the Si-ECL IC consumed a large power and required a large chip area.

## DETAILED DESCRIPTION OF THE INVENTION

Fig. 2 shows an equivalent circuit of a GaAs IC 500 according to an embodiment of the present invention. In the present IC 500, output transistors are represented by $Q_{30}$ and $Q_{31}$ and have their threshold voltage that is smaller (or larger in absolute value) than the output transistors $Q_{27}$ and $Q_{28}$ in Fig. 1. Since the transistors $Q_{30}$ and $Q_{31}$ have a small threshold voltage, and they produce the same drain currents as the transistor $Q_{27}$ and $Q_{28}$ with smaller gate width. The transistors $Q_{30}$ and $Q_{31}$ are thereby manufactured with a small size to reduce the chip area. The input stray capacitances of $Q_{30}$ and $Q_{31}$ are also made small. Therefore, the transistors $Q_{30}$ and $Q_{31}$ are driven by the first buffer amplifier composed of the transistors $Q_{20}$ to $Q_{26}$, the diodes $D_9$ and $D_{10}$ and the resistors $R_{12}$ to $R_{14}$. The second buffer amplifier 9 is thereby unnecessitated.

The first to fourth input circuit for the first to fourth input signals $IN_1$ to $IN_4$ and the differential type logic circuit as a latch circuit are the same as those in Fig. 1. The like reference characters are employed. Accordingly, for the compatibility with the Si-ECL IC and the high speed operation, the threshold voltages of the transistors $Q_1$ to $Q_{28}$ are -0.2 to -0.3 $\bar{V}$, and the resistance values of the resistors $R_1$, $R_3$, $R_5$ and $R_7$ are 1.3K$\Omega$, the values of the resistors $R_2$, $R_4$, $R_6$ and $R_8$ being 4.9K$\Omega$. The first power supply terminal 5 is grounded and the terminal 6 is applied with -5.2 $\bar{V}$. The transistors $Q_1$ to $Q_{26}$, $Q_{30}$ and $Q_{31}$ are N-channel type Schottky junction field effect transistors.

In the GaAs IC 500 according to the present embodiment, the threshold voltages of the output transistors $Q_{30}$ and $Q_{31}$ are designed to be -0.65 $\bar{V}$. Therefore, the characteristic of the drain current to the gate width in the transistors $Q_{30}$ and $Q_{31}$ is represented by a line 300 in Fig. 3. The transistors $Q_{30}$ and $Q_{31}$ have their current ability of 20 mA with their gate widths of 170 $\mu$m. As a result, the sizes of the transistors $Q_{30}$ and $Q_{31}$ is reduced to about one third of the transistors $Q_{27}$ and $Q_{28}$.

The input stray capacitance of a transistor also depends on its threshold voltage. However, the increase in the input stray capacitance caused by the increase in threshold voltage is suppressed below 20 % in this embodiment. As a result, the second buffer amplifier 9 shown in Fig. 1 is deleted. This result in the further decrease in the chip area and a remarkable reduction of a power consumption. The semiconductor chip area of the GaAs IC 500 is reduced by 30 to 40 % as compared to that of the GaAs IC 100. The power consumption is also decreased similarly.

Thus, the present invention provides a GaAs IC having compatibility with an Si-ECL IC without increasing a power consumption and a chip area.

It is desired for a GaAs IC that the rising time and falling time of an output signal are below 100 to 130 psec. In order to satisfy this requirement and obtain an input stray capacitance unnecessitating the second buffer amplifier 9 (Fig. 1), the threshold voltages of the output transistors $Q_{30}$ and $Q_{31}$ are favourably designed to be within a range between -0.6 $\bar{V}$ and -0.9 $\bar{V}$.

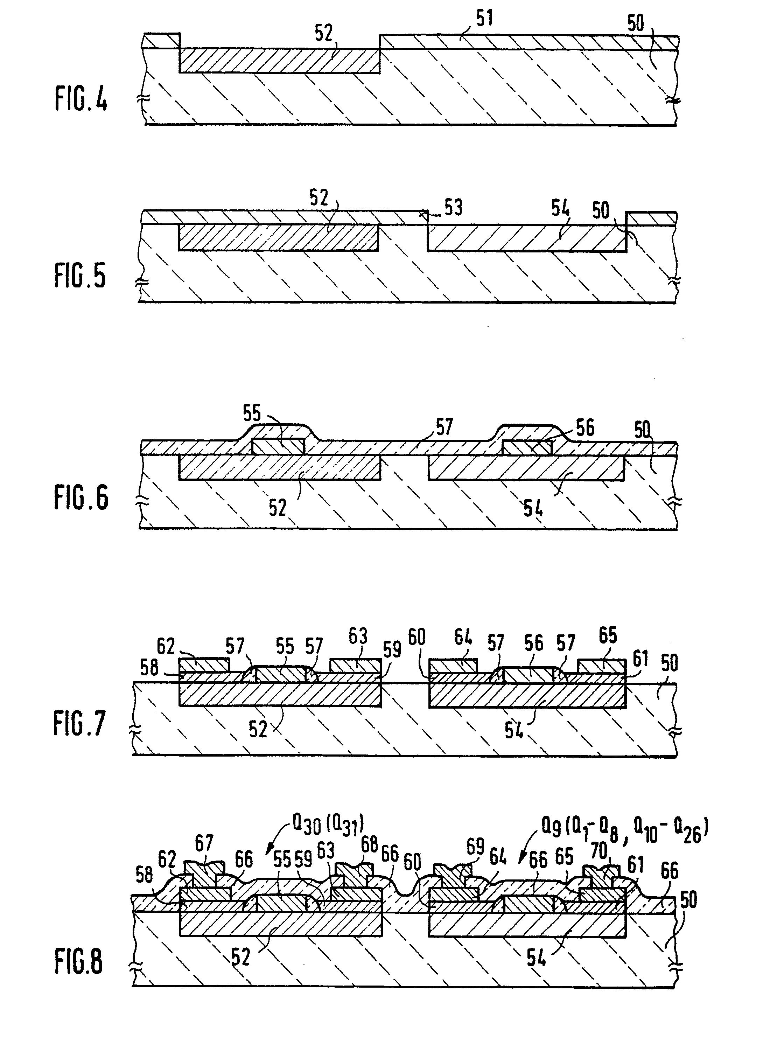

Fig. 4 to Fig. 8 show manufacturing steps of the output transistor $Q_{30}$ ($Q_{31}$) and the logic section transistor $Q_9$ ($Q_1$ to $Q_8$ and $Q_{10}$ to $Q_{26}$).

As shown in Fig. 4, a semi-insulating gallium arsenide substrate 50 is prepared, and a main surface thereof is covered selectively with a photoresist film 51. Si$^+$ ions are implanted into an exposed portion of the substrate 50 by ion implantation technique to form a channel region 52 of the output transistor $Q_{30}$ ($Q_{31}$).

The photoresist film 51 is then removed, and a new photo-resist film 53 is formed to cover selectively the surface of the substrate 50, as shown in fig. 5. Si$^+$ ions are implanted to the selective portion of the substrate 50 to form a channel region 54 of the transistor $Q_9$ ($Q_1$ to $Q_8$ and $Q_{10}$ to $Q_{26}$).

In the ion implantation condition for the channel region 52, the ion energy is 40 Kev, and the dose amount is 5 to 6 x $10^{12}$ cm$^{-2}$. On the other hand, the ion energy and the dose amount for the channel region 54 are 40 KeV and 4 x $10^{12}$ cm$^{-3}$, respectively. As a result, the channel region 52 presents -0.6 to -0.9 $\bar{V}$ threshold voltage to the output transistors $Q_{30}$ and $Q_{31}$, and the channel region 54 presents a threshold voltage below -0.3 $\bar{V}$

to the transistor $Q_1$ to $Q_{26}$.

The photoresist film 53 is removed, and a high melting point metal such as a tungsten silicide is deposited over the surface of the substrate 50 by the sputtering method. The high melting point metal is subjected to the selective dry etching, so that Schottky gate electrode 55 and 56 are formed as shown in Fig. 6. The gate width of the gate 55 is designed to present the above-mentioned current ability. Thereafter, an insulating film 57 such as silicon dioxide is deposited over the gate electrodes 55 and 56 and the surface of the substrate 50.

The film 57 is selectively removed, so that only on the side surfaces of the gate electrodes 55 and 56 the silicon dioxide 57 is left, as shown in Fig. 7. In order to reduce the internal source and drain resistances and to get a high conductance (gm), high carrier concentration layers 58 to 61 operating as source and drain regions are formed on the channel layers 52 and 54 by the chemical vapor deposition method. The side surface insulating films 57 separates the gate electrodes 55 and 56 from the layers 58 to 61. Since the high carrier concentration layers 58 to 61 is formed on the surfaces of the channel regions 52 and 54, the so-called short channel effect is suppressed remarkably. Moreover, the layers 58 to 61 present a high gm. in this embodiment, the value of gm is above 300 m$^s$/mm. Ohmic electrodes 62 to 65 are thereafter formed, which operate as source and drain electrodes and are made of Au/Ge-Ni.

As shown in Fig. 8, an insulating film 66 made of silicon dioxide is formed over the entire surface, and contact holes are formed in the film 66. Interconnection wiring layers 67 to 70 are then formed to construct the circuit shown in Fig. 2.

In this embodiment, only the dose amount is changed to obtain the output transistors $Q_{30}$ and $Q_{31}$ having the deep threshold voltage, and therefore the increase in cost is suppressed in a minimum value. It is possible that the ion energy is changed. That is, the carrier concentration of the channel regions of the output transistors $Q_{30}$ and $Q_{31}$ is increased to make the threshold values therof deep.

Further modifications are possible, for example, the transistors in the GaAS IC may be of a P-channel type, and output transistors of a source-grounded type may be employed.

## Claims

1. An integrated circuit device comprising a gallium arsenide substrate, a first power terminal (5) supplied with a ground voltage, a second power terminal (6) supplied with a first negative voltage substantially equal to -5.2V, a compound semiconductor substrate (50), a plurality of transistors (Q1 to Q26) formed on said compound semiconductor substrate, said plurality of transistors constituting a logic circuit connected between said first and second power terminals, an ECL- compatible output terminal (7, 8), and an output transistor (Q27, Q28) formed on said compound semiconductor substrate, connected between said first power terminal and said output terminal and having a first threshold voltage, said output terminal being connected through an externally provided load of 50 ohms to a potential source terminal (10), characterized in that all of said plurality of transistors have a second threshold voltage within a range from -0.2V to -0.3V wherein said first threshold voltage is within a range from -0.6V to -0.9V, that said potential source terminal (10) is supplied with a second negative voltage, that the source of said output transistor (Q27, Q28) is connected directly to the output terminal (7, 8), and that said output transistor is turned OFF in response to a first state of an output from said logic circuit and turned ON in response to a second state of said output from said logic circuit to produce logic levels that are compatible with those of silicon emitter-coupled logic integrated circuit devices.

## Revendications

1. Dispositif à circuit intégré comprenant un substrat en arséniure de gallium, une première borne d'alimentation (5) à laquelle est appliquée une tension de masse, une seconde borne d'alimentation (6) à laquelle est appliquée une première tension négative sensiblement égale à -5,2V, un substrat en semi-conducteur composé (50), une multitude de transistors (Q$_1$ à Q$_{26}$) formés sur le substrat de semi-conducteur composé, la multitude de transistors constituant un circuit logique monté entre les première et seconde bornes d'alimentation, une borne de sortie compatible LCE (7, 8) et un transistor de sortie (Q$_{27}$, Q$_{28}$) formé sur le substrat de semi-conducteur composé connecté entre la première borne d'alimentation et la borne de sortie et ayant une première tension de seuil, la borne de sortie étant reliée par l'intermédiaire d'une charge fournie extérieurement de 50 ohms à une borne (10) de source de potentiel, caractérisé en ce que la totalité de la multitude de transistors présente une seconde tension de seuil tombant dans la plage comprise entre -0,2V et -0,3V, dans laquelle la première tension de seuil est comprise dans la plage comprise entre -0,6V et -0,9V, en ce que la borne (10) de source de potentiel reçoit une seconde tension négative, en ce que la source du transistor de sortie ($Q_{27}$, $Q_{28}$) est connectée directement à la borne de sortie (7, 8), et en ce que le transistor de sortie est rendu non conducteur en réponse à un premier état d'une sortie provenant du circuit logique et rendu conducteur en réponse à un second état de la sortie du circuit logique pour produire des niveaux logiques qui sont compatibles avec ceux des dispositifs à circuit intégré logique couplé par émetteur en silicium.

## Patentansprüche

1. Integrierte Schaltungsvorrichtung mit einem Gallium-Arsenid-Substrat, einer ersten Netzklemme, die mit einer Massespannung gespeist wird, einer zweiten Netzklemme (6), die mit einer ersten negativen Spannung gespeist wird, welche im wesentlichen gleich -5.2V beträgt, einem Verbundhalbleitersubstrat (50), einer Anzahl Transistoren (Q1-Q26), die auf dem Verbundhalbleitersubstrat ausgebildet sind, wobei die Anzahl Transistoren einen logischen Schaltkreis bilden, der zwischen den ersten und zweiten Netzklemmen geschaltet ist, einer ECL-Kompatiblen Ausgangsklemme (7,8), und einem Ausgangstransistor (Q27,Q28), der auf dem Verbundhalbleitersubstrat ausgebildet ist, zwischen der ersten Netzklemme und der Ausgangsklemme geschaltet ist, und eine erste Schwellwertspannung hat, wobei die Ausgangsklemme über eine externe vorgesehene Last von 50 Ω an eine Spannungsquellenklemme (10) angeschlossen ist, dadurch **gekennzeichnet**, daß alle der Anzahl Transistoren eine zweite Schwellwertspannung innerhalb eines Bereiches von -0.2V bis -0.3V haben, wobei die erste Schwellwertspannung im Bereich von -0.6V bis -0.9V liegt, daß die Spannungsklemme (10) mit einer zweiten negativen Spannung gespeist wird, daß die Source des Ausgangstransistors (Q27,Q28) direkt an die Ausgangsklemme (7,8) angeschlossen ist, und daß der Ausgangstransistor in Abhängigkeit von einem ersten Status eines Ausgangssignals am logischen Schaltkreis AUS-geschaltet und in Abhängigkeit von einem zweiten Status des Ausgangssignals am logischen Schaltkreis EIN-geschaltet wird, um logische Pegel zu erzeugen, die mit denen von Silicium-Emittergekoppelten integrierten Logikschaltkreisen kompatibel sind.

FIG. 1

FIG. 2

EP 0 200 230 B1

FIG. 3

FIG.4

FIG.5

FIG.6

FIG.7

FIG.8